# EUROPEAN PATENT APPLICATION

(11) **EP 3 754 051 A1**
(43) Date of publication of application: **23.12.2020**
(21) Application number: 19382510.6
(22) Date of filing: 19.06.2019
(51) Int. Cl.: C25D 11/04, C23C 14/00, C23C 14/02, C23C 14/16, C23C 14/58, C23C 28/00, C25D 11/10, C25D 11/16, C25D 11/18, C25F 3/20, G03F 7/00, H01P 1/218

(54) **METHOD FOR NANOSTRUCTURED MATERIALS FABRICATION COMBINING SOFT LITHOGRAPHIC IMPRINT, ALUMINUM ANODIZATION AND METAL SPUTTERING**

(71) Applicant: Consejo Superior de Investigaciones Científicas (CSIC), 28006 Madrid (ES); Universidade Do Porto, 4099-002 Porto (PT)
(72) Inventor: VAZQUEZ VILLALABEITIA, Manuel, 28049 Madrid (ES); GONZÁLEZ TRABADA, David, 28049 Madrid (ES); NAVAS OTERO, David, 4099-002 Porto (PT)
(74) Representative: Pons Ariño, Angel

(57) **Abstract**

The present invention relates to a method for nanostructured materials fabrication combining soft lithographic imprint, aluminum anodization and metal sputtering which permits the preparation of highly ordered nanoporous alumina templates with straight lines, square lattice ordering, and others. The procedure is based on large-scale nanoimprint using patterned commercial disks as imprint media, followed by single anodization process and metal sputtering.

## Description

### OBJECT OF THE INVENTION

The present invention relates to a method for nanostructured materials fabrication combining soft lithographic imprint, aluminum anodization and metal sputtering which permits the preparation of highly ordered nanoporous alumina templates with straight lines, square lattice ordering, and others. The procedure is based on large-scale nanoimprint using patterned commercial disks as imprint media, followed by single anodization process and metal sputtering.

This technique constitutes a non-expensive method for mould production and pattern generation avoiding standard lithographical techniques useful in technologies such as for nano-photonic and magnonic devices.

### BACKGROUND ART

Aluminum oxide membranes with uniform pore size and long-range ordering of pores are required in many nanotechnology applications. The electrochemical route of anodization of aluminum foils is currently used to grow porous membranes. Double anodization process is customarily used to synthesize self-assembled arrays of pores ordered with hexagonal arrangement and tailored diameter and inter-pore distance [Li, A.P., Muller, F, Birner, A, Nielsch, K Gosele, U (1998) Hexagonal pore arrays with a 50-420 nm interpore distance formed by self-organization in anodic alumina. Journal of Applied Physics 84:6023-6026.]. These porous membranes are currently employed as templates to electroplate metallic elements or alloys of interest for nanotechnology applications without the need of expensive lithographical techniques.

An alternative procedure to reach ordered nanoporous alumina templates consists of the mechanical nanoimprinting by which the pattern of a hard stamp (mould) is transferred onto the aluminum surface by mechanical pressure, followed by a single anodization process [H. Masuda and K. Nishio. Synthesis and Applications of Highly Ordered Anodic Porous Alumina, Self-Organized Nanoscale Materials, Nanostructure Science and Technology 296-312 (2006).]. Therefore, the ordered pores will be arranged on the previously formed indentations.

Nanoimprint lithography was introduced by Chou et al. [Chou, S.Y., Krauss, P.R Renstrom, P.J (1996) Imprint Lithography with 25-Nanometer Resolution. Science 272:85-87] using a patterned mould, prepared by electron beam lithography, whose ordering was transferred onto a polymeric thin layer (PMMA) after an imprint process.

This concept was successfully applied for the fabrication of ordered nanoporous alumina templates after an anodization process of a pre-patterned aluminum substrate. That substrate is previously imprinted by a SiC master mould prepared by electron beam lithography [H. Masuda, H. Yamada, M. Satoh, H. Asoh, M. Nakao and T. Tamamura, Highly ordered nanochannel-array architecture in anodic alumina Appl. Phys. Lett., 71, 2770-2772 (1997)], and a Si₃N₄ [J. Choi, K. Nielsch, M. Reiche, R.B. Wehrspohn and U. Gösele, Fabrication of monodomain alumina pores arrays with an interpore distance smaller than the lattice constant of the imprint stamp. J. Vac. Sci. Technol. B, 21, 763-766 (2003)] or nickel master moulds prepared by interference lithography [W. Lee, R. Ji, Caroline A. Ross, U. Gosele, and K. Nielsch. Wafer-scale Ni imprint stamps for porous alumina membranes based on interference lithography, Small, 2, 978-982 (2006)].

Additional techniques used in the pre-treatment of aluminum include focus ion-beam [N.W. Liu, A. Datta, C.Y. Liu, and Y.L. Wang. High-speed focused-ion-beam patterning for guiding the growth of anodic alumina nanochannel arrays. Applied Physics Letters 82, 1281-1283 (2003)], scanning probe microscopy [H. Masuda, K. Kanezawa, and K. Nishio. Fabrication of Ideally Ordered Nanohole Arrays in Anodic Porous Alumina Based on Nanoindentation Using Scanning Probe Microscope. Chemistry Letters 31, 1218-1219 (2002)], atomic force microscopy [M. Jaafar, D. Navas, M. Hernandez-Velez, J.L. Baldonedo, M. Vázquez, and A. Asenjo. Nanoporous alumina membrane prepared by nanoindentation and anodic oxidation. Surface Science 603, 3155-3159 (2009).] and self-organized periodic array of polystyrene particles [M. Hideki, M. Yoshitaka, Y. Masato, M. Futoshi, and N. Kazuyuki. Fabrication of Highly Ordered Anodic Porous Alumina Using Self-organized Polystyrene Particle Array. Chemistry Letters 33, 584-585 (2004)].

Moreover, the combination of such nanoimprint lithography, using SiC moulds prepared by electron beam lithography, with subsequent single anodization process allows the preparation of defect-free alumina templates with different pore arrays ordering from the standard hexagonal-array [H. Masuda, H. Yamada, M. Satoh, H. Asoh, M. Nakao, and T. Tamamura. Highly ordered nanochannel-array architecture in anodic alumina. Applied Physics Letters, 71, 2770-2772 (1997)] to square- and triangle-array geometries [H. Asoh, S. Ono, T. Hirose, M. Nakao, and H. Masuda. Growth of anodic porous alumina with square cells. Electrochimica Acta, 48, 3171-3174 (2003)] [H. Masuda, H. Asoh, M. Watanabe, K. Nishio, M. Nakao, and T. Tamamura. Square and triangular nanohole array architectures in anodic alumina. Advanced Materials, 13, 189-192 (2001)].

On the other hand, complex 2-D patterned media were generated using a simple 1-D grating stamp by multiple imprinting onto different types of polymer films to enable the fabrication of square, rectangle, rhombus or triangular patterns [R. Mukherjee, A. Sharma, G. Patil, D. Faruqui, P. Sarathi, and G. Pattader. Soft lithography meets self-organization: Some new developments in meso-patterning. Bulletin of Materials Science, 31, 249-261 (2008)]. The two-step imprinting has been also reported in the literature to fabricate nanoporous alumina templates with multiple patterns from a single master mould [I. Mikulskas, S. Juodkazis, R. Tomasiunas, and J.G. Dumas. Aluminum Oxide Photonic Crystals Grown by a New Hybrid Method. Advanced Materials 13, 1574-1577 (2001)] [J. Choi, R.B. Wehrspohn, and A. Gösele. Moiré pattern formation on porous alumina arrays using nanoimprint lithography. Advanced Materials, 15, 1531-1534 (2003)].

However, the implementation of nanoporous alumina templates, using pre-patterned aluminum substrates, to industrial processes is expensive and complex as the small-scale imprint moulds have been usually fabricated by means of lithographic techniques. Therefore, large-scale (at least in the order of several cm²) and low-cost molds are required.

An alternative to overcome this limitation was based on the use of commercial nanostructured materials, such as Compact Discs (CD), as imprint stamps. Baquedano et al. [E. Baquedano, L. Torné, P. Caño, and P. A. Postigo. Increased Efficiency of Solar Cells Protected by Hidrophobic and Hydrophilic Anti-reflecting Nanostructured Glasses. Nanomaterials, 7, 437 (2017)] imprinted PMMA polymeric films using Compact Disc (CD), Digital Versatile Discs (DVD) and Blu-ray discs (BR) as low-cost moulds.

Also, document US2015/0064492A1 uses a CD mould to generate a polymeric PDMS stamp to achieve a NFO patterned thin film.

Moreover, document EP1279068B1 describes a method for transferring the nanostructured patterns of a CD mould onto a silicon oxide thin film. In this document, commercial compact discs have been introduced as imprint stamps to replicate their ordering onto the aluminum instead of more conventional lithographed moulds. In 1980, companies as Philips and Sony introduced a version of compact disc (CD) used as media for storing digital data in computer applications. Although a very useful medium for the recording data, demand for new media with higher storage capacity arose during the 90's that led to their evolution to the digital versatile discs (DVD) and later to the blue-ray (BR) disks. All these media consists typically of a 120 mm diameter polycarbonate disk with a thickness of 1.2 mm. For DVD and CD, the disk is coated with a reflective aluminum layer on which several protective layers of polycarbonate are placed.

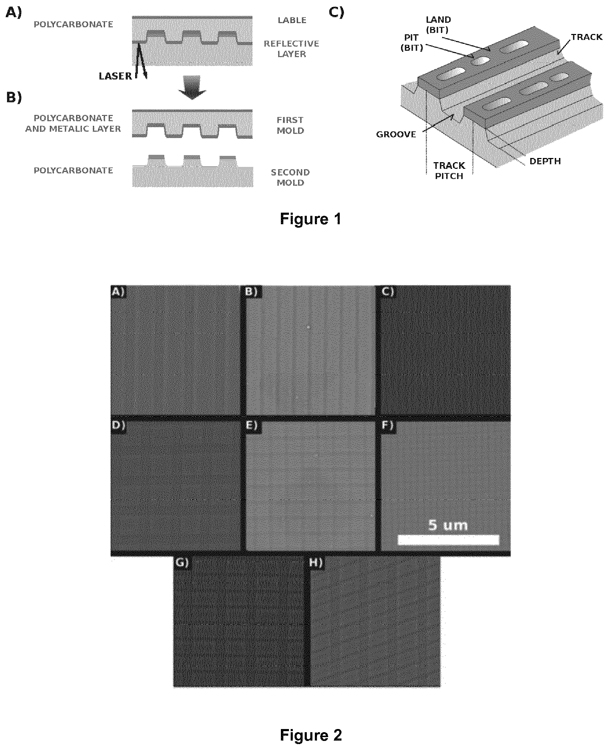

The thickness of the aluminum foil on top of the polycrystalline structure is very small as compared with the polycarbonate mould which is grown by injection of polycarbonate plastic (see Figure 1A). Although the reflective coating is different for BR, its physical structure is similar to DVD and CD. Figure 1B shows the hard polycarbonate mould containing complementary stripped surface features. The track pitch in Figure 1C denotes the space between consecutive lines that contain deeper zones with the groove (stripe width) and the land.

There are several mass-produced brands offered in the market. Although available erasable/re-writable optical disks are not completely identical to each other, the clean stamp has similar land and groove dimensions. The writable layer in all these alternatives form a spiral track of data circling from the centre of the disc to its external side. The diameter of a typical disk is much larger than the separation between consecutive lines of increasing diameter and hence under SEM, the lines appear parallel with nearly infinite radius of curvature. Table 1 collects the geometrical parameters of various optical disks.

**Table 1.- Track Pitch, Groove and Lands of different polycarbonate optical disks used as stamps. Polyc: Polycarbonate, ML: Polycarbonate stamp with the metal layer, ST: Polycarbonate stamp with simple track**

| Optical Disc | Polyc. | Pitch (nm) | Groove (nm) | Land (nm) | Depth (nm) | Thickness (nm) | Nomenclature |
|---|---|---|---|---|---|---|---|
| CD | ML | 1600 | 600 | 1000 | 130 | 0.1 | CD-ML |
| CD | ST | 1600 | 1000 | 600 | 130 | 1.1 | CD-ST |
| DVD | ML | 740 | 320 | 420 | 65 | 0.6 | DVD-ML |
| DVD | ST | 740 | 420 | 320 | 65 | 0.6 | DVD-ST |
| BR | ML | 320 | 130 | 190 | 40 | 1.1 | BR-ML |
| BR | ST | 320 | 190 | 130 | 40 | 0.1 | BR-ST |

Ferromagnetic nanopatterned thin films have been used for the development of magnonic devices. In analogy to photonic crystals, magnonic crystals are magnetic materials with periodic distribution of the constituent materials or some magnetic parameters, such as the saturation magnetization or magnetocrystalline anisotropy, as well as the modulation of other important parameters for the propagation of spin waves (the external magnetic field, film thickness, stress or surroundings of the homogeneous ferromagnetic film) [S. Neusser, and D. Grundler, Magnonics: Spin Waves on the Nanoscale, Adv. Mater. 21, 2927 (2009).] [V. V. Kruglyak, S. O. Demokritov, and D Grundler, Magnonics, J. Phys. D: Appl. Phys. 43, 264001 (2010).]. In particular, 2D magnonic crystals and devices with a planar geometry and fabricated from a single magnetic material, such as ferromagnetic antidot arrays [C. C. Wang, A. O. Adeyeye, and N. Singh, Magnetic antidot nanostructures: effect of lattice geometry, Nanotechnology 17, 1629 (2006).] [N. G. Deshpande, M. S. Seo, X. R. Jin, S. J. Lee, Y. P. Lee, J. Y. Rhee, and K. W. Kim, Tailoring of magnetic properties of patterned cobalt antidots by simple manipulation of lattice symmetry, Appl. Phys. Lett. 96, 122503 (2010).], or different materials, such as chessboard-like arranged micromagnets [G. Gubbiotti, S. Tacchi, M. Madami, G. Carlotti, S. Jain, A. O. Adeyeye, and M. P. Kostylev, Collective spin waves in a bicomponent two-dimensional magnonic crystal, Appl. Phys. Lett. 100, 162407 (2012).] have been prepared.

However, the implementation of these nanostructures into technological applications is rather difficult as the fabrication process requires of several lithographic and deposition steps. From the preceding paragraphs, it is concluded that there is a need for a method, which combining soft lithographic imprint, aluminum anodization and metal sputtering, provides nanostructured materials, particularly 2D magnonic crystals with unique two dimension thickness modulation.

### BRIEF DESCRIPTION OF THE INVENTION

Large-scale nanoimprint moulds are introduced for aluminum imprinting followed by a single anodization process. The obtained ordered nanostructures are used as templates for subsequent sputtering of magnetic structures.

In a first aspect, the invention relates to a method for nanostructured materials fabrication combining soft lithographic imprint, aluminum anodization and metal sputtering comprising:
- providing highly-pure aluminum foils (at least 99.999%) with a diameter ranging from 16 to 20 mm and a thickness ranging from 0.2 to 0.5 mm
- electrochemical polishing of the highly-pure aluminum foils by means of treatment in a mixture solution of perchloric acid and ethanol
- providing a master mould for imprinting selected from CD, DVD and BR discs
- pressing the master mould on the aluminum foil with a pressure ranging from 10 to 200 Kg/cm⁻² thereby imprinting any patterns of the discs to the aluminum foil.
- anodization processing of pre-patterned aluminum foil under constant voltage, ranging from 80 to 195 V, in a reagent selected from phosphoric, malic or oxalic acid in concentrations ranging from 0.01 to 0.03 M at temperatures between 0°C and 5°C, and during a period ranging from 10 min to 10 h.
- metallic sputter coating onto the nanoporous alumina template in a high vacuum chamber at a pressure ranging from 1.1 x 10⁻² to 1.3 x 10⁻² mbar with normal incidence. The deposition rate of the metallic sputter coating is few nm/s, such as between 2.9 and 3.3 nm/s, to grow a metallic layer with thicknesses ranging from 5 to 200 nm.

In a preferred embodiment, the reagent selected for anodization processing of pre-patterned aluminum foil is phosphoric acid.

In a preferred embodiment, the method comprises a single imprint process before the anodization step so that geometry is characterized by parallel nanostripes.

In another preferred embodiment, the method further comprises a second imprint process before the anodization step and with the mould rotated at an angle ranging from 1° to 90°. Within this option, porous alumina templates with different geometries, such as square and rectangular configuration is obtained when in the second imprint the mould is rotated by 90° and rhombic nanostructures, with defined parameters, are achieved when in the second imprint the mould is rotated by an angle between 1° and 90°.

In preferred embodiments, the material for the metallic sputter coating is selected from iron, cobalt, nickel and their alloys.

In preferred embodiments, the specific geometry determined by the mentioned single and double-imprint processes results in films or coating with defined magnetic anisotropy.

A second aspect of the invention refers to the use of the anodized and coated lithographic imprint obtained by a method as previously defined in nano-photonic and magnonic devices. The magnonic device may be a 2D magnonic crystal formed by a ferromagnetic antidot thin film in which the allowed spin waves frequencies and forbidden frequency gaps are determined by the antidot pattern design. This system displays a controlled two dimension thickness modulation of the ferromagnetic material according to different geometries (lines, triangles or squares), which is not available to achieve using other standard fabrication processes such as those based on lithography techniques. This extra degree of freedom should achieve to get a higher control on the spin waves propagation spectra.

The process of the invention differs from the disclosure by Masuda et al. [H. Masuda and K. Nishio. Synthesis and Applications of Highly Ordered Anodic Porous Alumina, Self-Organized Nanoscale Materials, Nanostructure Science and Technology 296-312 (2006)] in that the commercial stamps, selected from CD, DVD and BR discs, are used as moulds. These commercial systems allow the fabrication of low-cost and large-area (in the order of several cm²) pre-patterned aluminum substrates and avoiding the usually used master moulds prepared by lithographic methodologies.

Although CD, DVD and BR moulds were used for the fabrication of nanostructured materials by the nanoimprint of polymeric [E. Baquedano, L. Torné, P. Caño, and P. A. Postigo. Increased Efficiency of Solar Cells Protected by Hidrophobic and Hydrophilic Anti-reflecting Nanostructured Glasses. Nanomaterials, 7, 437 (2017) [US2015/0064492A1] or SiO₂ [EP1279068B1] thin films, this document describes the pattern transfer to a metallic substrate such as aluminum following by an anodization process.

Finally, the process of invention includes the fabrication of sputtered nanostructured materials with ferromagnetic properties so that, they can be functionalized for various applications based on its specific magnetic response, importantly determined by its magnetic anisotropic behavior.

### BRIEF DESCRIPTION OF THE FIGURES

**Fig. 1****:** Schematic diagrams of: (A) cross section view showing the thin Al foil (in blue) on top of an optical disk media; (B) two polycarbonate molds, one of them showing a sputtered layer at its upper surface; (C) grooves and tracks of the mould; bits (in purple) contain the data in an optical disc.
**Fig. 2****:** SEM images of stripes (single-imprint step) and square/rhombic (double- imprint step) patterns on aluminium after imprinting. Stripes are in (A) to (C), squares in (D) to (F), rectangle in (F) and rhombus in (G). Stripes and squares in (A) and (D) are for a CD-ML mould; in (B) and (E) for a DVD-ML mould; and in (C) and (F) for a BR-ML mould. (G) and (H) are rectangle and rhombic patterns respectively prepared by double-imprint step and 90° or 60° rotation between each one. Lateral separation between neighbouring stripes is 1600, 740 and 320 nm for (A), (B) and (C), respectively. Both lateral and longitudinal separation distances between neighbouring squares and rectangles are 1600, 740 and 320 nm for (D), (E) and (F), respectively. The lateral distance in (G) is 740 nm, and the longitudinal distance in (H) is 320 nm. The stripe and the square side width are 1000 nm, 420 nm and 190 nm for (A-D), (B-E) and (C-F), respectively. The rectangle is 420 x 190 nm² for (G-H).
**Fig. 3****:** SEM images of DVD-ML stripe patterned alumina. Top (A) and lateral (B) views for a sample anodized at 160 V in 0.1M H₃PO₄ and at 5° C. (C) and (D) correspond to top and lateral views for a sample anodized under 195 V in 0.03 M H₃PO₄ and at 5°C. Lateral cross-section views are obtained after breaking the samples. The scale bar in image C is the same for all the figures. The observed double-striped structure is 540 nm wide and the interpore distance is 200 nm for both samples.
**Fig. 4****:** Schematic view of the pore arrangement during anodization process of the pre-patterned Al. The red lines represent a guide to the eye to follow the self-ordering of pores (points) into the pre-patterned structure (lines).
**Fig. 5****:** Top-view SEM images (A-B) of an array of Co double-nanostripes (50 nm thick). In (C), individual Co double-nanostripes and the remaining transversal connections (marked) are observed.
**Fig. 6****:** Top view schematic diagram of the two stripes in the pre-patterned aluminum substrate (A), after an anodization process (B) and with an sputtered cobalt thin layer (C).
**Fig. 7****:** SEM images of squared Co nanodots ordered into a cubic arrangement (A, B).
**Fig.8****:** In-plane azimuthal dependence of VSM hysteresis loops of ordered Co double-nanostripes of different thickness (20 nm A, 50 nm D and 100 nm G). The corresponding angular dependence of coercivity, Hc, and fractional remanence, Mᵣ/Mₛ, are given in (B, E and H) and (C, F and I), respectively. The reference 0° corresponds to parallel alignment of the applied field with the nanostripes.
**Fig. 9****:** Representative VSM loops at selected polar angles of the applied field for 50 nm thick Co nanostripes (A). The angular dependence of coercivity (B) and fractional remanence, Mᵣ/Mₛ (C), are also given.
**Fig. 10****:** Longitudinal (A) and transversal (D) MOKE hysteresis loops, and corresponding angular dependence of coercivity (B, E) and reduced remanence Mᵣ/Mₛ (C, F) for 50 nm thick Co nanostripes.
**Fig.11****:** A, B, C: Representative in-plane azimuthal angle dependence of VSM hysteresis loops (A) together with the corresponding dependence of coercivity, Hc, (B) and of fractional remanence, Mᵣ/Mₛ, (C) for a cubic array of squared Co nanodots.
   D, E, F: Representative VSM hysteresis loops at selected polar angles of the applied field for 20 nm thick Co squared nanodots (D). The angular dependence of coercivity (E) and fractional remanence Mᵣ/Mₛ (F) are also given.
**Fig.12****:** Patterns obtained by means of multiple imprints at rotated angles.
**Fig.13** DVD-ML triangle patterned.

### DETAILED DESCRIPTION AND EMBODIMENTS OF THE INVENTION

Patterned disks from a compact disc (CD), digital versatile disc (DVD) and blue-ray (BR) have been used as thin flexible masters for imprinting in aluminum foils with specific geometrical arrangements. After the imprinting, single anodization process was performed to obtain anodic porous alumina masks/templates with different patterns. Then, sputtering technique was employed to grow magnetic stripes. A particular study of the magnetic properties of stripe DVD-ST thin films with different geometric parameters has been also carried out.

### Example 1: Synthesis of ordered large nanostructures by combined imprint and anodization

### a) Synthesis of imprint-patterned aluminium foils:

Highly-pure (99,999%) aluminum foils (diameter and thickness of 20 mm and 0.5 mm, respectively) were electrochemically polished in a mixture solution of perchloric acid and ethanol. Afterwards the master mould was pressed with an oil press which can apply up to 2800 kg/cm². Commercial optical CD and DVD disks, Verbatim-trademark [www.verbatim.com] without mask or serigraphy were used as stamps.

This imprint process transfers the particular patterns of CD, DVD or BR disks to the aluminum substrate as observed in Figure 2 showing the SEM images of stripes and square/rhombic patterns. The different brightness of the area indicates the different surface heights, brighter areas denote the higher location of the lands and the darker ones correspond to deeper grooves. After the imprint process, stripes are generated (see Figures 2A to 2C). A second imprint processes can be performed with the mould rotated at 90° angle to obtain square arrays (Figures 2D to 2F). The versatility of these two-imprint processes allows one to generate arrays with alternative rectangular (Figure 2G) and rhombic (Figure 2H) geometries.

### b) Synthesis of ordered alumina nanostructures by anodization of imprint-patterned aluminum foils:

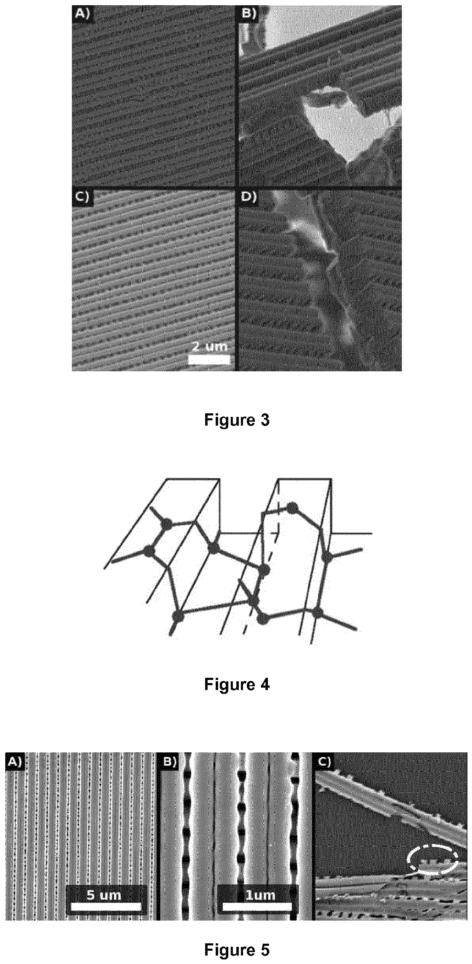

After the (single or double) imprint process, a single anodization process was conducted under constant voltage of 160 V in 0.1 M H₃PO₄ (Figure 3A and B) or 195 V in 0.03 M H₃PO₄ (Figures 3C and D) at 5°C and during 2 hours. The anodization in such a diluted phosphoric acid does not affect the interpore distance of the pre-patterned aluminum foil. The anodization under higher voltage (e.g., 195 V) results in sharper edges and the pores present a better defined surface shape (Figures 3C and 3D) than the one at lower voltage (e.g., 160 V) (Figures 3A and 3B).

Importantly, it is to be noticed that after anodization, each high land area of the original nanostructured aluminum becomes a double-stripe anodic nanostructure with the presence of aligned pores at the middle that nearly contact each other. In addition, the anodization promotes the formation of pores along the corner region between land and groove. The pores generated by the anodization grow following a kind of hexagonal arrangement on the pre-patterned imprint structure, as schematically shown in Figure 4 avoiding a random nucleation of pores. During the anodization the aluminum surface oxidizes and induces an additional expansion that results in different width at the bottom of the groove.

### Example 2: Synthesis of ordered Co nanostructures on anodic-imprint templates

### a) Synthesis of ordered Co nanostripes

After the imprint and anodization processes, samples were sputter-coated with Co in a high-vacuum home-made chamber with an argon pressure work of 1.2x10⁻² mbar and a base pressure below 2.5x10⁻⁴ mbar. The sputtering was performed with normal incidence. A deposition rate of 3.1 nm/s determined the Co layer thickness. Three samples are here analysed with 20, 50 and 100 nm thickness, respectively.

The SEM images in Figures 5 correspond to the 50 nm thick sputtered Co sample where longitudinal Co double-nanostripe structures are observed with a lateral periodical modulation, arising from the original patterned structure. Such double nanostripe configuration reproduces the anodic nanostructure showed in Figure 3, and introduces novel magnetic response later described in Example 3. The modulation is also interpreted to be a consequence of the anodization process in connection with the observed transversal understructure (see Figure 5B) that corresponds to sputtered Co on the groove zones. Figure 5C shows individual Co double-nanostripes together with remaining transversal structures (marked in dashed lines) after the striped alumina membrane matrix was dissolved by a mix solution of phosphoric and chromic acids at 50°C for 10 min.

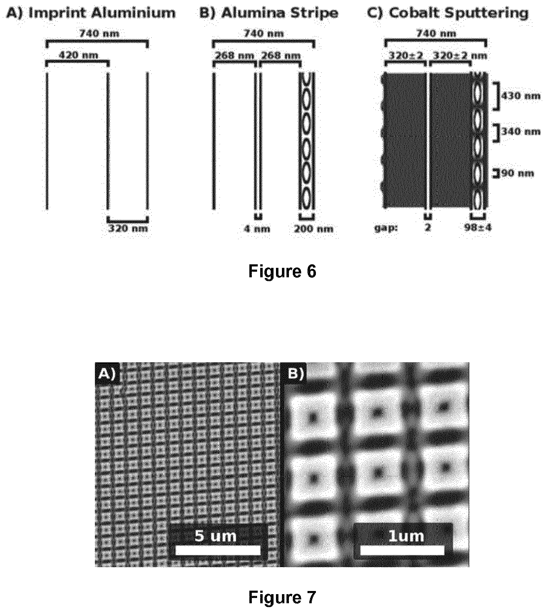

Figure 6 shows schematic views and the geometry parameters after imprint (A), after anodization (B) and after sputtering (C). Note that the widths of the land and the groove of the imprinted aluminum stripe are 420 nm and 320 nm, respectively. After anodization the width of the double-nanostripe increases to 540 nm seemingly as a consequence of the aluminum expansion and the pores formation at the middle line of the double-stripe giving rise to a nearly frustrated thin line. In parallel, anodization reduces the width of the groove from 320 nm to 200 nm and produces a kind of modulated porous structure at the groove.

The sputtering process generates the Co film and reduces overall the diameter of the nanopores generated by the anodization. On top of the land, Co film nearly closes the pores at the center of the double-nanostructure whose effective width becomes around 626 nm (for 50 nm thick Co film). The sputtering also reaches the groove and enhances a modulated understructure that connects neighboring double-nanostripes. The dimensions of that nanostructure are given in Figure 6 (C).

Finally, the structural characterization of Co double-stripes was performed with an X'Pert PRO x-ray diffractometer with Cu K radiation. Standard θ-2θ scans were performed to collect the XRD spectra that confirm the presence in Co stripes of *hcp* crystal symmetry with (002) texture. The average grain size of Co stripes is of around 160 nm.

### b) Synthesis of squared arrays of Co nanodots

In order to grow ordered arrays of Co nanodots with cubic symmetry we make use of the ordered nanostructures shown in Figure 2E after a double-step imprint at 90° followed by an anodization process. Then, Co is sputtered onto them in a similar way as indicated in the previous section. Figure 7 (A and B) show the SEM images of an array of ordered Co nanodots 20 nm thick. As observed, the nanodots take near-squared shape, 420 nm in side, with an ellipsoidal hole at the center around 100 nm long and 70 nm wide. They are separated 320 nm and are arranged into a macroscopic squared configuration. Note that the hole at the center of the nanodots as well as the distorted squared shape are consequence of the aluminum expansion process induced during the anodization process which, similarly to the case of Co nanostripes, gives rise to an understructure.

### Example 3: Magnetic characterization of ordered Co nanostructures

An overall magnetic characterization has been carried out in the ordered Co nanostructures. Special attention has been paid to their hysteretic behavior and their magnitudes i.e., coercivity, *H_{c}*, and fractional remanence, *M*/*Mₛ*. A vibrating sample magnetometer, VSM (EV7 KLA-Tencor), was employed under a maximum applied field of 17 kOe for such a characterization. The experimental setup allowed the rotation of the sample so that it was possible to determine both the azimuthal (in-plane) and the polar (out-of-plane) angular dependence of their magnetic characteristics.

Complementary information has been obtained using magneto-optical Kerr effect magnetometer (NanoMOKE2 from Durham Magneto Optics Ltd). The reduced laser beam spot (nominally 3 µm) allows one to obtain local MOKE hysteresis loops. It allows for the simultaneous determination of the parallel or longitudinal and transversal magnetization components to the field direction. The magnetic quadrupole system of the setup allows applying magnetic field as large as 600 Oe. While VSM measurements supply information about the bulk magnetic properties, MOKE data will give information of the surface magnetic behavior. Typically, the laser penetration depth goes up to 20 nm so that MOKE will inform us of different information specifically in the thickest samples.

### a) Co double-nanostripe ordered arrays

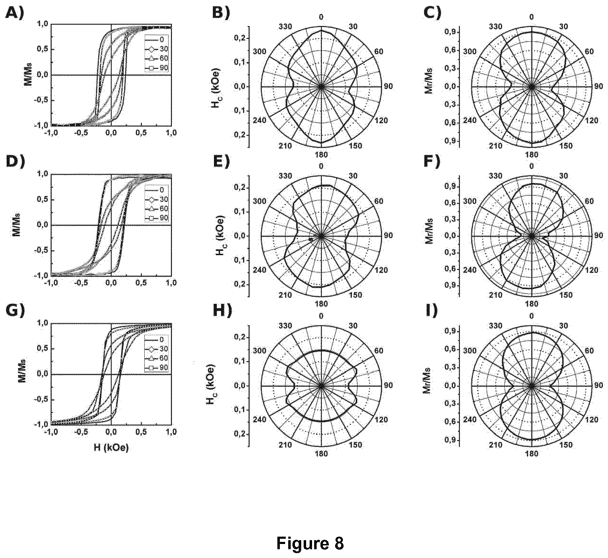

Figure 8 shows the azimuthal angle dependence of the hysteresis loops under in-plane applied field configuration for Co double-nanostripes with thickness of 20 (A), 50 (D) and 100 (G) nm. In all the cases, the hysteresis loops show nearly a square shape with a single giant Barkhausen jump for a configuration of the applied field parallel to the nanostripes (0°). The loops become progressively S-shaped with decreasing susceptibility as the orientation of the magnetic field rotates towards the perpendicular orientation (90°). The measurements indicate that maximum coercivity, *H_{c},* and fractional remanence, *Mᵣ*/*Mₛ*, values are obtained nearly along the direction parallel to the nanostripes indicating that this corresponds to the magnetization easy axis in all the three samples. The perpendicular orientation of the applied field roughly corresponds to a magnetization hard axis.

The angular dependence of coercivity for the nanostripes 20 nm (B) and 50 nm (E) thick can be explained assuming a strong nearly uniaxial shape anisotropy originating in the high length to thickness aspect ratio of the nanostripes. In fact, an additional anisotropic term should be considered to understand the local angular coercivity maxima at around 60° and 120°. This effect is even more pronounced in the case of the thicker nanostripes (e.g., 100 nm, in Fig. 8 H). The occurrence of such double or secondary maximum value for the coercivity indicates that the anisotropy is not fully uniaxial but containing kind of four-fold anisotropy. The origin for that four-fold symmetry is ascribed to the very unique presence of double-stripes together with the transversal understructures. Note however that as far as the remanence angular profile is concerned (Figures 8C, F and I), only the main two-fold anisotropy is observed.

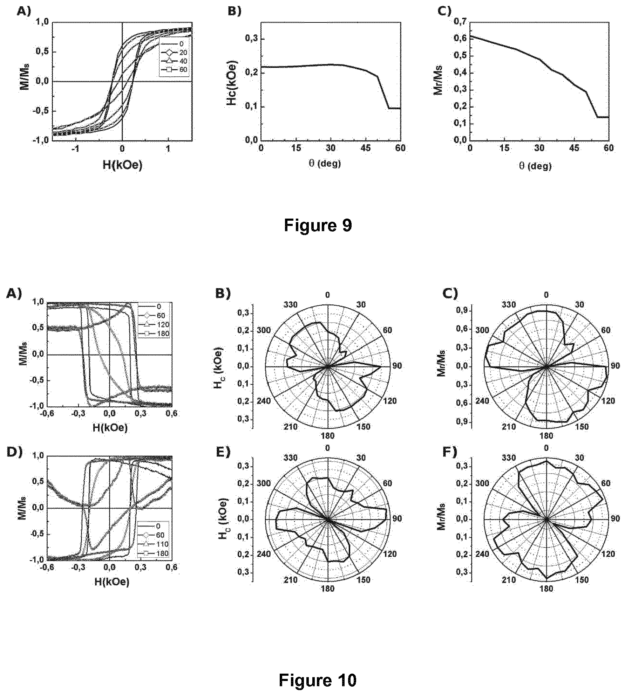

Additional characterization was carried out by out-of-plane VSM measurements as well as by in-plane magneto-optical Kerr effect. Here, we present few selected data on specific samples for general information. Figure 9 shows out-of-plane VSM measurements as a function of the polar angle of the applied field with regards to the plane of the nanostripes for the 50 nm thick Co double-nanostripe arrays. Angular data were taken from applied field parallel (0°) to perpendicular to the nanostripes (90°). The hysteresis loops show maximum values for coercivity and remanence for the smaller angular values which denotes the presence of an overall magnetization easy axis in the plane of the nanostripes. Moreover, a comparison between the hysteresis loops and their parameters for in-plane and out-of-plane measurements in Figures 8 and 9, respectively, confirm the presence of an in-plane easy magnetization axis in the Co double-nanostripes. That is interpreted to derive essentially from the overcoming anisotropy shape.

Finally, magneto-optical Kerr effect measurements for the Co double-nanostripe sample, 50 nm thick, are shown in Figure 10. Such surface hysteresis loops show similar maximum values of coercivity (e.g., around 0.2 kOe) and fractional remanence Mr/Ms (e.g., 0.8) in comparison with in-plane VSM loops (see Figure 8). However, the combined angular data from longitudinal and transverse Kerr effect suggests the presence of a nearly uniaxial anisotropy making an angle of around 30° to 45° (e.g., 315° to 330°) with the nanostripes axis. This discrepancy could be attributed to a slightly different effective anisotropy orientation at the surface of the nanostripes originating in the pores distribution.

### b) Co square nanodots ordered arrays

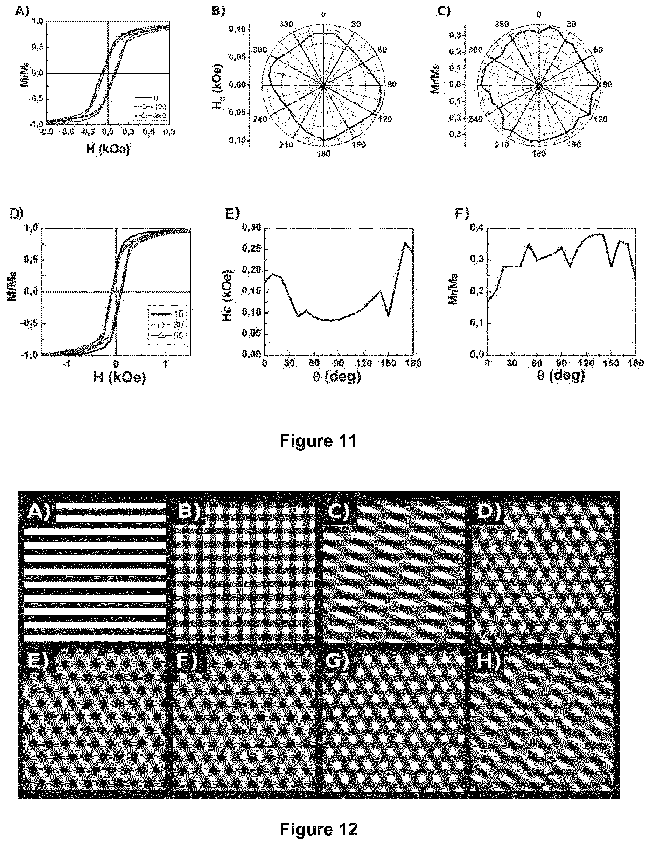

A rough magnetic characterization was carried out in the Co squared nanodots arrays. Figure 11 shows the VSM hysteresis loops for the Co square nanodot array and its in-plane angular dependence (0° orientation corresponds to the direction parallel to the side of the square dot). The hysteresis loops are clearly inclined with regards to the in-plane loops for the arrays of Co double-nanostripes (see Figure 8) which results in a comparatively reduced remanence. In addition, the angular dependence is much more reduced than in the case of Co nanostripes. All that appears to result from the less defined shape anisotropy that in addition gives rise to a comparatively much smaller coercivity. A deeper analysis of the angular dependence of coercivity and remanence suggests the presence of a modest in-plane bi-axial magnetic anisotropy with magnetization easy axes at 90° to each other.

### Example 4: Obtention of complex 2D patterns by means of multiple imprints at rotated angles.

Complex 2D pattern were generated using a simple 1D grating stamp by multiple imprinting, this technique allows for the fabrication of square, rectangle, rhombus and even triangle patterns.

Therefore, the mould is used to imprint the aluminum foil directly. Figure 12 shows the schematic views of some different patterns that can be achieved: single nanostripe stripe is showed in Figure 12A, while the superposition of stripe pattern generates the ideal square (Figure 12 B) or rhombic (Figure 12 C) patterns at two imprint process (as described previously). An additional third imprint is needed to obtain triangular patterning (Figure 12 D), where the angle between imprints is rotated by 60° instead of 90° as for square or rectangular configurations.

Moreover, Figures (E), (F), (G) and (H) show the superposition of three imprints and using different stamps.

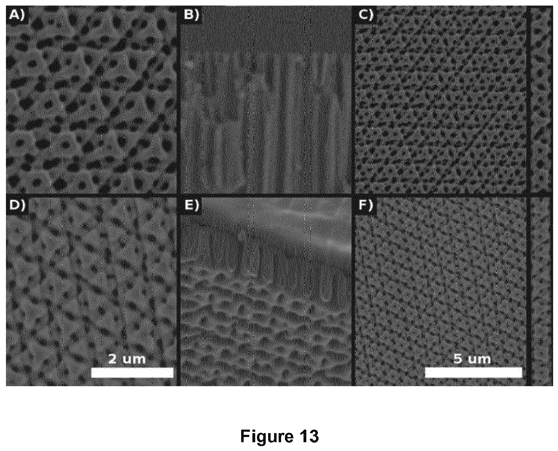

Figure 13 displays triangular patterned alumina templates prepared by means of a DVD-ML stamp mould. SEM images (Figures 13A-C) show a triangle patterning, top- (A and C) and cross section (B) views of a sample prepared at 160 V in 0.1 M H₃PO₄ and at 5°C. Sample shown in Figures 13D-F was prepared at 195 V in 0.03 M H₃PO₄ and at 5°C.While Images (A), (B), (D) and (E) use the same scale-bar, images (C) and (F) are a zoom-out of (B) and (E) figures, respectively. At the right side, the arrangement cell lattice of the samples is showed.

## Claims

1. Method for nanostructured materials fabrication combining soft lithographic imprint, aluminum anodization and metal sputtering comprising:
- providing an aluminum foil of at least 99.999% purity with a diameter ranging from 16 to 20 mm and a thickness ranging from 0.2 to 0.5 mm
- electrochemical polishing of said aluminum foils by means of treatment in a mixture solution of perchloric acid and ethanol
- providing a master mould for imprinting selected from CD, DVD and BR discs
- pressing the master mould with the aluminum foil at a pressure ranging from 10 to 200 Kg/cm⁻², thereby imprinting any patterns of the discs to the aluminum foil
- anodization processing of pre-patterned aluminum foil under constant voltage, ranging from 80 to 195 V, in a reagent selected from phosphoric, malic or oxalic acids with concentrations ranging from 0.01 to 0.03 M at temperatures between 0°C and 5°C, and during a period ranging from 10 min to 10 h
- metallic sputter coating onto the nanoporous alumina template in a high vacuum chamber at a pressure ranging from 1.1 x 10⁻² to 1.3 x 10⁻² mbar and with normal incidence with a deposition rate of the metallic sputter coating between 2.9 and 3.3 nm/s.

2. Method for nanostructured materials fabrication combining soft lithographic imprint, aluminum anodization and metal sputtering according to claim 1, **characterized in that** it further comprises a second imprint process with the mould rotated at an angle ranging from 1° to 90°.

3. Method for nanostructured materials fabrication combining soft lithographic imprint, aluminum anodization and metal sputtering according to anyone of claims 1 or 2, **characterized in that** the reagent selected for anodization processing of the pre-patterned aluminum foil is a phosphoric acid solution.

4. Method for nanostructured materials fabrication combining soft lithographic imprint, aluminum anodization and metal sputtering according to anyone of claims 1 to 3 , wherein the material for the metallic sputter coating is selected from iron, cobalt, nickel and their alloys.

5. Method for nanostructured materials fabrication combining soft lithographic imprint, aluminum anodization and metal sputtering according to claim 4, wherein the metal for the metallic sputter coating is selected from cobalt and nickel-iron alloy.

6. Use of an anodized and coated lithographic imprint obtained by a method as defined in claims 1 to 5 in nano-photonic and magnonic devices.
